# EUROPEAN PATENT APPLICATION

(11) **EP 2 009 679 A1**
(43) Date of publication of application: **31.12.2008**
(21) Application number: 07012358.3
(22) Date of filing: 25.06.2007
(51) Int. Cl.: H01L 21/033, H01L 29/786

(54) **Semiconductor device**

(71) Applicant: Interuniversitair Microelektronica Centrum (IMEC), 3001 Leuven (BE)
(72) Inventor: Lenoble, Damien, 1050 Ixelles (BE); Collaert, Nadine, 3052 Blanden (BE)
(74) Representative: Bird, Ariane

(57) **Abstract**

The present invention provides a method for forming a semiconductor device (10) on a substrate (1) having a first major surface lying in a plane. The method comprises, after patterning the substrate (1) to form at least one structure (20) extending from the substrate (1) in a direction substantially perpendicular to the plane of the major surface of the substrate, forming locally modified regions (6) at locations in the substrate which are not covered by the at least one structure (20), thus locally increasing etching resistance of these regions (6). Forming locally modified regions may prevent under-etching of the at least one structure during further process steps in the formation of the semiconductor device (10). Forming locally modified regions (6) may be performed by implanting implantation elements into regions of the substrate (1) not covered by the at least one structure (20). The present invention furthermore provides a semiconductor device obtained by the method according to embodiments of the invention. The semiconductor devices according to embodiments of the invention have good electrical properties and good mechanical stability.

## Description

### Technical field of the invention

The present invention relates to a method for forming a semiconductor device on a substrate, e.g. a bulk semiconductor substrate or a semiconductor-on-insulator substrate, and to a semiconductor device thus obtained. The semiconductor device obtained with a method according to the present invention comprises locally modified regions with increased etching resistance. This leads to semiconductor devices with improved properties such as good electrical properties and good mechanical stability.

### Background of the invention

Silicon on insulator (SOI) technology refers to the use of a layered silicon-insulator-silicon substrate in semiconductor manufacturing, especially microelectronics. SOI substrates comprise a thin, insulating layer, such as silicon oxide or glass, between a thin layer of silicon and a silicon bulk substrate. SOI-based devices thus differ from conventional silicon-built devices in that the silicon junction is above an electrical insulator, typically silicon dioxide.

An example of an SOI-based device is a FinFET (fin field-effect transistor). A FinFET comprises a thin silicon (Si) fin with a gate running over the fin. The gate controls a channel at least along the sidewalls of the fin. The electrical width of the channel is defined by the geometrical dimensions of the fin, particularly by the height and the width of the fin. A distinguishing characteristic of a FinFET with respect to other semiconductor devices is that a conducting gate is wrapped around the thin Si fin which forms the body of the device.

In FinFET fabrication, the use of SOI substrates with a silicon layer on a buried oxide (BOX) may, after patterning of the silicon layer of the SOI substrate, lead to formation of recesses in the BOX and under-etch regions in the BOX under the patterned silicon layer. These BOX recesses and under-etch regions may be formed during further processing of the FinFET, for example during removal of a hardmask used to pattern the silicon layer. Residues of materials used during further processing of the FinFET may stick in these BOX recesses and especially in the under-etch regions. An additional process step may then be necessary to remove these residues. However, the residues may be difficult to remove and may thus still be present in the final FinFET. This may have an impact on the electrical properties of the device formed on the substrates, may degrade the mechanical stability of the FinFET and may degrade the device matching, yield, etc.

The above-described problem may in general arise with any semiconductor device formed on a substrate, e.g. bulk semiconductor substrate or semiconductor-on-insulator substrate, lying in a plane, in which the semiconductor device is formed of a structure extending from the substrate in a direction substantially perpendicular to the plane of the substrate.

### Summary of the invention

It is an object of the present invention to provide a good method for forming a semiconductor device on a substrate, e.g. semiconductor bulk substrate or semiconductor-on-insulator substrate, and a semiconductor device obtained by the method according to embodiments of the invention.

Semiconductor devices obtained by the method according to embodiments of the invention may have improved properties such as improved electrical properties and improved mechanical stability.

The above objective is accomplished by a method and device according to the present invention.

In a first aspect of the invention, a method is provided for forming a semiconductor device on a substrate having a first major surface lying in a plane. The method comprises:
- patterning the first major surface of the substrate to form at least one structure extending from the substrate in a direction substantially perpendicular to the plane of the first major surface of the substrate, and
- forming locally modified regions at locations in the substrate which are not covered by the at least one structure, thus locally increasing etching resistance of these regions.

With increasing etching resistance is meant that the locally modified regions have a reduced etching speed compared to the original, non-modified substrate. Locally increasing etching resistance may prevent under-etching of the at least one structure during further process steps in the formation of the semiconductor device.

By providing locally modified regions at locations in the substrate not covered by the at least one structure these regions are protected during process steps during further processing of the semiconductor device, e.g. etching steps, such that formation of recesses and under-etched regions in the substrate may be prevented.

The method according to embodiments of the invention may lead to semiconductor devices with good electrical properties and good mechanical stability.

According to embodiments of the invention the substrate may be a semiconductor-on-insulator substrate, such as a silicon-on-insulator (SOI) substrate, a germanium-on-insulator (GOI) substrate or a silicon-germanium-on-insulator (SGOI) substrate. According to these embodiments the invention may provide a method for forming a semiconductor device on a semiconductor-on-insulator substrate comprising a semiconductor layer on an insulating layer having a surface. The method may comprise:
- patterning the semiconductor layer, hereby forming at least one structure extending from the substrate in a direction substantially perpendicular to the plane of the major surface of the substrate and exposing part of the surface of the insulating layer, and
- forming locally modified regions in the insulating layer at locations which are not covered by the at least one structure, thus locally increasing etching resistance of these regions. Forming locally modified regions may prevent under-etching of the at least one structure during further process steps in the formation of the semiconductor device.

The insulating layer may be a buried oxide.

According to embodiments of the invention, the substrate may be a bulk semiconductor substrate having a major surface lying in a plane, and the method may comprise:
- patterning the bulk semiconductor substrate, hereby forming the at least one structure extending from the substrate in a direction substantially perpendicular to the plane of the major surface of the substrate, and
- forming locally modified regions in the bulk semiconductor substrate at locations which are not covered by the at least one structure, thus locally increasing etching resistance of these regions. Forming locally modified regions may prevent under-etching of the at least one structure during further process steps in the formation of the semiconductor device.

According to embodiments of the invention, the substrate may have a major surface lying in a plane. Forming locally modified regions in the substrate may be performed by implanting implantation elements, also called species or implantation species, in a direction substantially perpendicular to the plane of the major surface of the substrate. With "implantation elements", "species" and "implantation species" in the light of the present invention is meant the same thing: elements suitable to be implanted into a semiconductor or insulating layer. With substantially perpendicular is meant that the direction of implantation of the implantation elements may most preferably make an angle of between 0 and 5 degrees with a direction substantially perpendicular to the plane of the major surface of the substrate such that substantially no implantation elements can enter the at least one structure through its sidewalls. With substantially no implantation elements entering the at least one structure is meant that a concentration of preferably less than 1 E12 cm⁻² and more preferably less than 1 E10 cm⁻² of implantation elements may enter the at least one structure during implantation of implantation elements to form the locally modified regions.

An advantage hereof is that implantation elements are not implanted in sidewalls of parts of the semiconductor device formed on the substrate. For example, in case of a FinFET, implantation elements are not implanted in sidewalls of the fin.

Implanting implantation elements may, according to embodiments, be performed by ion implantation.

According to embodiments of the invention, implanting implantation elements may be performed by plasma doping. An advantage of plasma doping or PLAD is that this technique allows implantation of implantation elements in a direction substantially perpendicular to the plane of the major surface of the substrate, i.e. at an incidence angle of substantially zero degrees with a direction substantially perpendicular to the plane of the major surface of the substrate. PLAD furthermore allows implantation of high doses of implantation elements of 1E13 to 1E17 cm⁻² such that a peak of implantation elements is located at the surface of the substrate not covered by the at least one structure.

The implantation elements may comprise carbon, nitrogen, oxygen or a combination thereof.

According to embodiments of the invention, the method may furthermore comprise extending the locally modified regions under the at least one structure. Extending the locally modified regions under the at least one structure may be performed by annealing. Annealing may be performed at a temperature of between 800°C and 1000°. Annealing may be performed during a time period of between 1 second and 60 seconds. Annealing may lead to formation of locally modified regions with a thickness of between 1 nm and 20 nm.

According to embodiments of the invention, patterning the substrate may be performed by:
- providing a mask onto the substrate, and
- removing parts of the substrate which are not covered by the mask.

Providing a mask may comprise providing a hardmask comprising at least one of a metal, a nitride, an oxide or a low-k material.

According to other embodiments, providing a mask may comprise providing a photoresist polymer.

In a second aspect of the invention, a semiconductor device is provided comprising at least one structure extending from a substrate having a major surface lying in a plane, the structure extending in a direction substantially perpendicular to the plane of the major surface of the substrate, wherein the semiconductor device furthermore comprises locally modified regions in the substrate at locations not covered by the at least one structure, the locally modified regions having an increased etch resistance with respect to the etch resistance of the non-modified substrate.

The semiconductor devices according to embodiments of the invention have good electrical properties and good mechanical stability.

According to embodiments of the invention, the substrate may be a semiconductor-on-insulator substrate, such as a silicon-on-insulator (SOI) substrate, a germanium-on-insulator (GOI) substrate or a silicon-germanium-on-insulator (SGOI) substrate. According to these embodiments, the invention may provide a semiconductor device comprising at least one structure formed of a patterned semiconductor layer on an insulating layer of the semiconductor-on-insulator substrate, the insulating layer having a surface and the semiconductor device furthermore comprising locally modified regions in the insulating layer at locations which are not covered by the patterned semiconductor layer. The locally modified regions may have an increased etching resistance compared to the original, non-modified substrate. According to these embodiments, the insulating layer may be a buried oxide.

According to the specific embodiments where the substrate is a semiconductor-on-insulator substrate, the locally modified regions in the insulating layer may comprise SiOₓN_{y}, wherein x and y are integers with x+y = 1, meaning that given the dose range obtainable with PLAD (see further), any stoichiometric combination of, for example, (Si, O, N) or (Si , 0) or (Si, N) may be obtained in the locally modified regions in the semiconductor-on-insulator substrate. Alternatively, and as an example only, the locally modified regions in the insulating layer may comprise SiOₓC_{y}, wherein x and y are integers with x+y = 1.

According to other embodiments of the invention, the substrate may be a bulk semiconductor substrate. For example, the bulk semiconductor substrate may be any of a bulk silicon substrate, a bulk Ge substrate, a bulk GaAs substrate, a bulk GaN substrate.

The locally modified regions may be regions implanted with carbon, nitrogen, oxygen or a combination thereof.

The locally modified regions may have a concentration of implantation elements, e.g. a carbon, nitrogen or oxygen concentration of between 1E13 cm⁻² and 1E17 cm⁻².

The locally modified regions may have a thickness of between 1 nm and 20 nm.

Optionally, the locally modified regions may extend underneath the at least one structure.

According to specific embodiments, the semiconductor device may be a FinFET.

An advantage of the device according to embodiments of the present invention, is that by providing locally modified regions in a substrate or part of a substrate, e.g. a buried oxide (BOX) of an SOI (silicon-on-insulator) substrate or part of a bulk semiconductor substrate, at locations which are not covered by a part of the semiconductor device, the substrate or part of the substrate is protected during further processing of the semiconductor device such that formation of recesses and under-etched regions in the substrate or part of the substrate may be prevented.

The device obtained by the method according to embodiments of the present invention may have good electrical properties and a good mechanical stability.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 to 6 illustrate subsequent steps in a manufacturing process for a FinFET on an SOI substrate according to embodiments of the invention.
Fig. 7 to 10 illustrate subsequent steps in a manufacturing process for a semiconductor device on a bulk semiconductor substrate according to embodiments of the invention.
Fig. 11 shows a Scanning Spreading Surface Resistance Microscopy (SSRM) profile of a bulk FinFET doped using Plasma Doping (PLAD) illustrating an embodiment of the invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the terms top, over, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

Reference will be made to transistors. These are three-terminal devices having a first main electrode such as a drain, a second main electrode such as a source and a control electrode such as a gate for controlling the flow of electrical charges between the first and second main electrodes. It will be clear for a person skilled in the art that the present invention is also applicable to similar devices that can be configured in any transistor technology, including for example, but not limited thereto, CMOS, BICMOS and Bipolar technology.

The present invention provides a method for forming a semiconductor device on a substrate having a first major surface lying in a plane . The method comprises:
- patterning the first major surface of the substrate to form at least one structure extending from the substrate in a direction substantially perpendicular to the plane of the first major surface of the substrate, and
- forming locally modified regions at locations in the substrate which are not covered by the at least one structure so as to locally increase etching resistance of these regions. Forming locally modified regions may prevent under-etching of the at least one structure during further process steps in the formation of the semiconductor device.

A device obtained by a method according to embodiments of the present invention may have good electrical properties and a good mechanical stability.

The method according to embodiments of the invention may advantageously be used in the formation of a semiconductor device, e.g. a finFET, on a semiconductor-on-insulator substrate for protecting the insulating layer of the semiconductor-on-insulator substrate by preventing under-etching of the at least one structure formed on the substrate during further process steps in the formation of the semiconductor device. However, according to other embodiments, the method may also be advantageously used in the formation of a semiconductor device, e.g. a finFET, on a bulk semiconductor substrate for protecting part of the semiconductor substrate not covered by the at least one structure by preventing under-etching of the at least one structure formed on the substrate during further process steps in the formation of the semiconductor device. According to a first embodiment of the invention, the substrate may be a semiconductor-on-insulator substrate comprising a semiconductor layer on an insulating layer. The substrate may, for example, be a silicon-on-insulator (SOI) substrate, a germanium-on-insulator (GOI) substrate or a silicon-germanium-on-insulator (SGOI) substrate. According to the first embodiment, a method may be provided for forming a semiconductor device on a semiconductor-on-insulator substrate, the semiconductor-on-insulator substrate comprising a semiconductor layer, e.g. silicon layer, on an insulating layer, e.g. a buried oxide, having a surface. The method according to these embodiments may comprise:
- patterning the semiconductor layer, hereby forming the at least one structure and exposing part of the surface of the insulating layer, and
- forming locally modified regions in the insulating layer, e.g. buried oxide, at locations which are not covered by the patterned semiconductor layer, or in other words which are not covered by the at least one structure, so as to locally increase etching resistance of these regions. Forming locally modified regions may prevent under-etching of the at least one structure during further process steps in the formation of the semiconductor device.

An advantage of the method according to the first embodiment of the present invention, is that by providing locally modified regions in the insulating layer, e.g. buried oxide (BOX), of the semiconductor-on-insulator substrate at locations which are not covered by a part of the semiconductor device, the insulating layer, e.g. buried oxide, is protected during further processing of the semiconductor device such that formation of recesses and under-etched regions in the insulating layer may be prevented.

Hereinafter, a method for the manufacturing of a FinFET (Fin Field-effect Transistor) on a silicon-on-insulator (SOI) substrate according to the first embodiment of the present invention will be described. It has to be understood that this is not intended to limit the invention in any way and that the method according to embodiments of the invention can be used for manufacturing any semiconductor device on any semiconductor-on-insulator substrate.

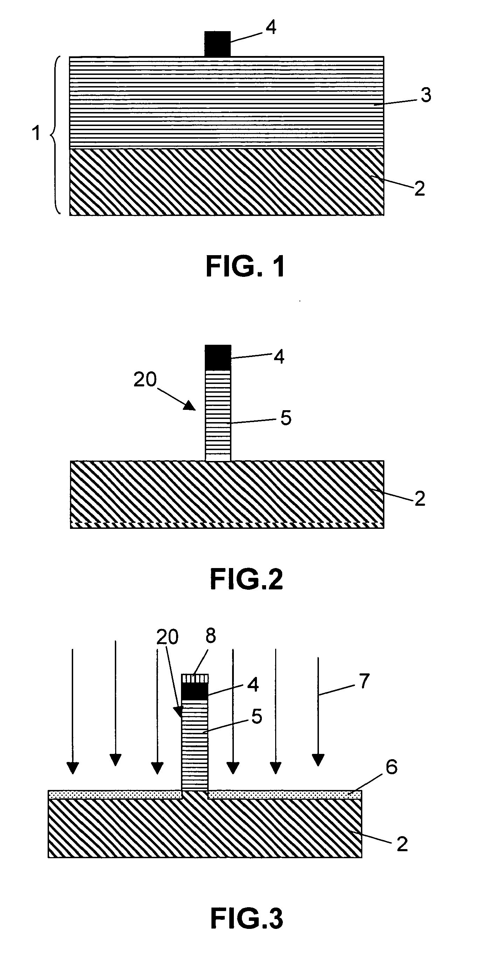

Fig. 1 to Fig. 6 illustrate subsequent steps in a method for manufacturing a FinFET 10 according to embodiments of the invention.

In a first step, an SOI substrate 1 comprising a bulk substrate (not shown in the figures), an insulating layer such as a buried oxide 2 and a silicon layer 3 is provided. The buried oxide 2 may typically have a thickness of between 50 nm and 200 nm and may, for example, be 150 nm. The buried oxide 2 may preferably comprise SiO₂. The silicon layer 3 may typically have a thickness of between 10 nm and 100 nm and may, for example, be 65 nm.

Next, the silicon layer 3, of which an upper surface (surface away from the buried oxide 2) forms a major surface of the SOI substrate 1, is patterned so as, to form at least one structure 20, in the example given at least one fin (see further), extending from the substrate 1 in, when the major surface of the substrate 1 is lying in a plane, a direction substantially perpendicular to the plane of the major surface of the substrate 1. In the example given, only one structure 20 is present on the substrate 1. It has to be understood that this is only for the ease of explanation and that this is not intended to limit the invention in any way. According to embodiments of the invention, the substrate 1 may comprise any number of structures 20 required to form a particular semiconductor device 10. Patterning of the silicon layer 3 may be hardmask-based or may be done by photolithography using a photoresist. In the example illustrated, a hardmask layer may be provided on the silicon layer 3. The hardmask layer may have a thickness of between 50 nm and 100 nm and may, for example, be 70 nm. The hardmask layer may, for example, comprise a metal such as e.g. Ti, Au, Ag, Pd, a nitride such as e.g. TiN, TaN, HfN, Si₃Ni₄, an oxide, such as e.g. TiO₂, SiO₂, a low-k dielectric or a combination, e.g. a stack, of the above materials. The thickness of the hardmask layer may preferably be such that, when implantation of implantation elements is performed in a later step of this method, the hardmask layer may act as a shield for preventing implantation elements to reach the patterned silicon layer or, in general, the at least one structure (see further). The hardmask layer may then be patterned and etched to form hardmask 4 which only covers the silicon layer 3 at the location where a fin 5 of the FinFET 10 is to be formed and leaves the other parts of the silicon layer 3 exposed (see Fig. 1). The exposed part of the silicon layer 3 may then be removed, e.g. by etching. Etching may, for example, be performed by a wet etch, a dry etch or a combination thereof. The structure obtained after etching the silicon layer 3 is illustrated in Fig. 2. The patterned silicon layer forms the fin 5 of the FinFET 10. The fin 5 may have a width of between 5 nm and 30 nm. The height of the fin 5 depends on the thickness of the silicon layer 3 of the SOI substrate 1 and may thus be between 10 nm and 100 nm. According to the first embodiments, the removal of the exposed part of the silicon layer 3 is up to exposure of the underlying insulating layer 2.

In a next step, implantation of implantation elements is performed (indicated with arrows 7 in Fig. 3) to form locally modified regions 6 in the exposed parts of the buried oxide 2. Therefore, implantation is performed at locations in the buried oxide 2 which are not covered by the fin 5. The implantation elements are such that the etching resistance of these regions 6 is increased. With increased etching resistance is meant that the locally modified regions 6 have a reduced etching speed with respect to the original, non-modified, substrate 1. Most preferably, the implantation elements may be C, N, O or a combination thereof. Preferably, an implantation dose of between 1E13 cm⁻² and 1 E17 cm⁻² may be used. During implantation of the implantation elements in the buried oxide 2, the hardmask 4 may act as a shield for preventing implantation elements to be implanted in the fin 5. This is because the presence of implantation elements in the fin 5 can lead to increased sidewall roughness of the fin 5. Furthermore, the presence of implantation elements in the fin 5 may lead to scattering of mobile carrier elements which may affect mobility of these mobile carriers in the fin 5. According to embodiments of the invention, implantation may be performed in an anisotropic way. Implantation may most preferably be done, when the SOI substrate 1 has a major surface lying in a plane, in a direction substantially perpendicular to the plane of the major surface of the substrate 1. With substantially perpendicular is meant that the direction of implantation of the implantation elements may most preferably make an angle of between 0 and 5 degrees with the direction substantially perpendicular to the plane of the major surface of the substrate 1 such that substantially no implantation elements can enter the fin 5 through its sidewalls which are not covered by the mask 4. With substantially no implantation elements entering the fin 5 is meant that a concentration of preferably less than 1E12 cm⁻² and more preferably less than 1E10 cm⁻² of implantation elements may enter the fin 5 during implantation of implantation elements to form the locally modified regions 6. In this way, implantation elements can be implanted without affecting the physical and electrical properties of the sidewalls of the fin 5. Therefore, most preferably, implantation may be performed with PLAD (plasma doping). PLAD allows implantation of implantation elements in a direction, when the SOI substrate 1 has a major surface lying in a plane, substantially perpendicular to the plane of the major surface of the SOI substrate 1 so that there is no space charge effect, i.e. no occurrence of localised excess charge. In PLAD a plasma, i.e. a cloud of ions near the surface of the substrate 1 to be implanted, in the example given the insulating layer 2 of the SOI substrate 1, is created. From this plasma, ions are extracted and accelerated towards and into the insulating layer 2.

PLAD allows a collisionless ion sheath which leads to an incidence angle of substantially 0 degree. Furthermore, PLAD allows high dose implantation of 1e13 to 1e17 cm⁻². Extraction voltages may be in the order of kV. By using PLAD a peak of implantation elements is located at the surface of the substrate 1, in the present embodiment the revealed buried oxide 2. In this way the buried oxide 2 is locally modified at those locations where implantation is performed. However, according to other embodiments, implantation of implantation elements may also be performed by any other known conventional implantation technique such as e.g. ion implantation, as long as the direction of implantation is substantially perpendicular to the plane of the major surface of the substrate 1 as defined above. According to other embodiments of the invention, any plasma having an anisotropic character may be applied for implanting implantation elements, e.g. remote plasma or RIE. The only disadvantage for such plasma may be that it has lower acceleration voltage (~300V) and hence the penetration depth is much less, e.g. 1 nm. Nevertheless, this may be sufficient depth for particular applications.

During implantation of implantation elements the hardmask 4 which is still present on the fin 5 may act as a shield for preventing implantation elements to be implanted into the fin 5. Therefore, the thickness and the material properties of the hardmask 4 should be chosen such that after implantation only a part 8 of the hardmask 4 is implanted with implantation elements and that the implantation elements are substantially not able to reach the fin 5. By implanting the implantation elements in a direction substantially perpendicular to the plane of the major surface of the SOI substrate (1), substantially no implantation elements are implanted in side walls of the fin 5, as already described above.

After implantation of the implantation elements in the exposed parts of the buried oxide 2, the locally modified regions 6 may optionally be extended underneath the fin 5. This may preferably be performed by annealing the SOI substrate 1. Annealing may be performed at temperatures of between 800°C and 1000°C for a period of between 1 second and 60 seconds. When the implantation elements that have been implanted for example comprise N, the locally modified regions 6 may comprise SiOₓN_{y}, wherein x and y are integers with x+y = 1, meaning that, given the dose range obtainable with PLAD, any stoichiometric combination of, for example, (Si, O, N) or (Si, 0) or (Si, N) may be obtained in the locally modified regions 6 in the SOI substrate 1. The locally modified regions 6 may have a thickness t in the buried oxide 2 of, for example, between 1 nm and 20 nm, preferably between 1 nm and 10 nm.

The presence of locally modified regions 6 in accordance with embodiments of the present invention may be detected by, for example, chemical analysis of the substrate, for example, by filtered transmission electron microscopy (TEM).

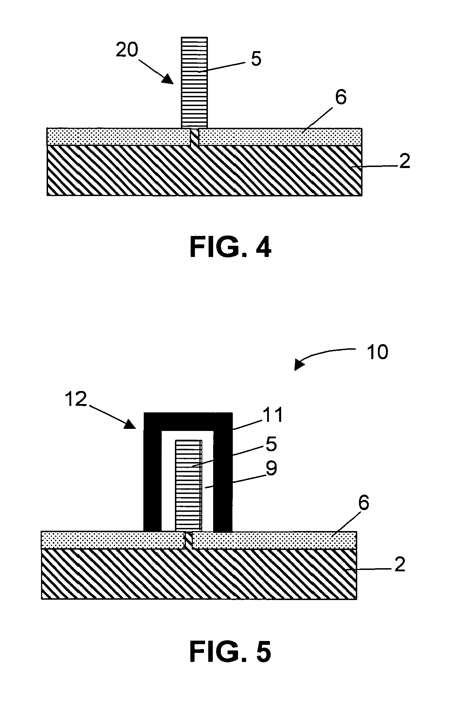

In a next step, the hardmask 4 may be removed (see Fig. 4). This may be done by any suitable technique known by a person skilled in the art, such as stripping.

In a further step, a dielectric layer 9 may be deposited with on top a conductive layer 11 to form a stack. Then, the stack may be patterned to form the gate 12 of the FinFET (see Fig. 5).

Further manufacturing of the FinFET 10 may be done as known by a person skilled in the art. For example, source and drain extensions and source and drain regions may be formed as known by a person skilled in the art.

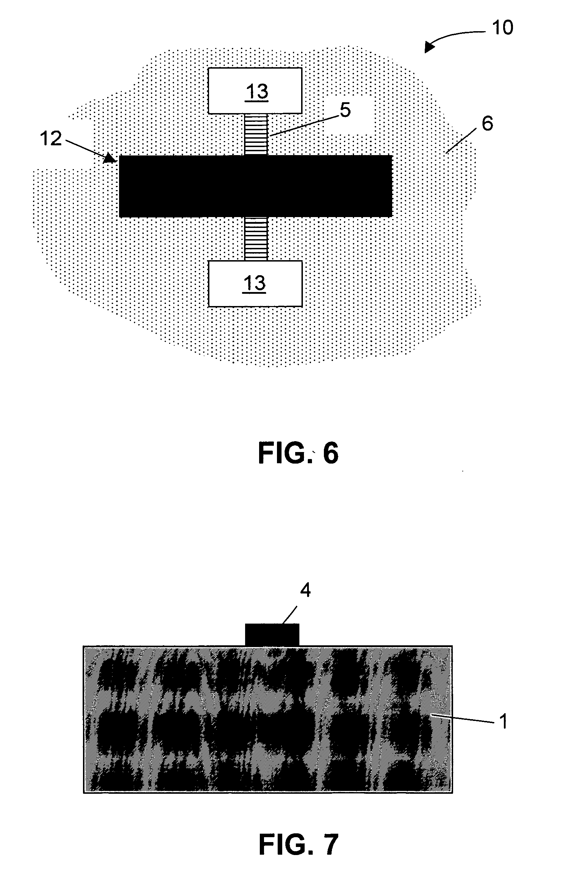

Figure 6 shows a top view of the device 10 as formed by the method as described above. The fin 5 is located between source and drain regions 13. This fin 5 is partly overlapped by the gate 12. The exposed area's of the underlying substrate 1, or in other words, the area's not covered by the fin 5, are modified to form the locally modified regions 6 with increased etching resistance with respect to the original buried oxide 2.

During process steps performed after formation of the locally modified regions 6, these locally modified regions 6 with increased etching resistance protect the buried oxide 2 against influence of materials and chemicals further used during manufacturing of the FinFET 10. This prevents recesses and under-etch regions under the fin 5 to be formed in the buried oxide 2. Hence, residues of materials or chemicals further used during the manufacturing of the FinFET 10 cannot stick in these recesses and under-etch regions as they do not exist. Hence, no additional process steps are required for removing these residues.

According to a second embodiment of the invention, the substrate 1 may be a bulk semiconductor substrate. The method according the second embodiment may be similar to the method as described for the first embodiment of the invention and is illustrated in Fig. 7 to 10.

First, a bulk semiconductor substrate 1 is provided. The bulk semiconductor substrate 1 may be any suitable semiconductor substrate 1 onto which a semiconductor device 10 may be formed. For example, the bulk semiconductor substrate 1 may be any of a bulk silicon substrate, a bulk Ge substrate, a bulk GaAs substrate, a bulk GaN substrate.

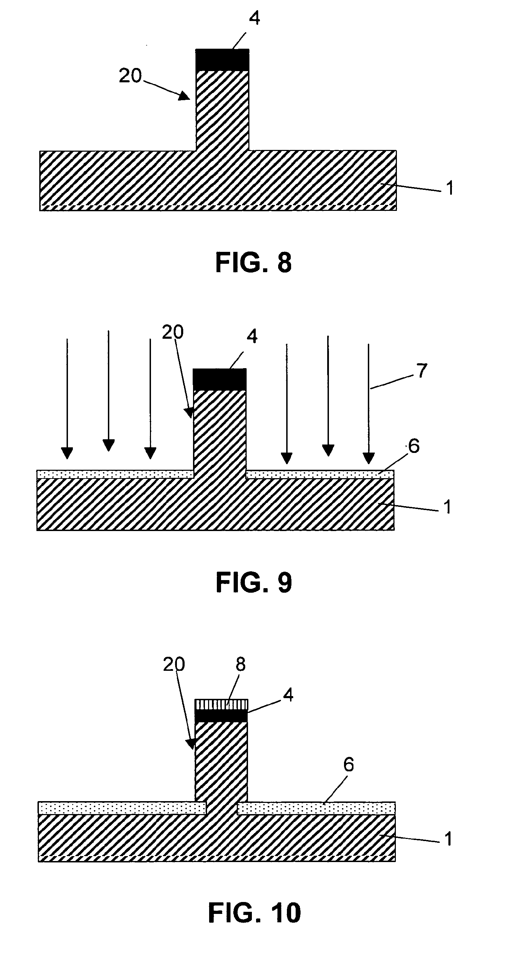

In a next step, a major surface of the bulk semiconductor substrate 1 is patterned so as to form at least one structure 20 extending from the substrate 1 having a major surface lying in a plane. When the major surface of the substrate 1 is lying in a plane, patterning is performed in a direction substantially perpendicular to the plane of the major surface of the substrate 1. In the example given, only one structure 20 is present on the substrate 1. It has to be understood that this is only for the ease of explanation and that this is not intended to limit the invention in any way. According to embodiments of the invention, the substrate 1 may comprise any number of structures 20 required to form a particular semiconductor device 10. Patterning of the bulk semiconductor substrate 1 may be hardmask-based or may be done by photolithography using a photoresist. In the example illustrated in Fig. 7 to 10, a hardmask layer may be provided on the bulk semiconductor substrate 1. The hardmask layer may have a thickness of between 50 nm and 100 nm and may, for example, be 70 nm. The hardmask layer may, for example, comprise a metal such as e.g. Ti, Au, Ag, Pd, a nitride such as e.g. TiN, TaN, HfN, Si₃Ni₄, an oxide, such as e.g. TiO₂, SiO₂, a low-k dielectric or a combination, e.g. a stack, of the above materials. The thickness of the hardmask layer may preferably be such that, when implantation of implantation elements is performed in a later step of this method, the hardmask layer may act as a shield for preventing implantation elements to reach the at least one structure 20 formed (see further). The hardmask layer may then be patterned and etched to form hardmask 4 which only covers the bulk semiconductor substrate 1 at the location where a the at least one structure 20 is to be formed and leaves the other parts of the bulk semiconductor substrate 1 exposed (see Fig. 7). The exposed parts of the bulk semiconductor substrate 1 may then be removed, e.g. by etching. Etching may, for example, be performed by a wet etch, a dry etch or a combination thereof. The structure obtained after etching the bulk semiconductor substrate 1 is illustrated in Fig. 8. The patterned silicon layer forms the at least one structure 20 of the semiconductor device 10. The at least one structure 20 can during further processing of the semiconductor device 10 be used to form e.g. a gate. The amount, i.e. thickness of removal of the exposed part of the bulk semiconductor substrate 1 depends on the kind of semiconductor device 10 to be formed.

In a next step, implantation of implantation elements is performed (indicated with arrows 7 in Fig. 9) to form locally modified regions 6 in those parts of the bulk semiconductor substrate 1 which are not covered by the at least one structure 20. The implantation elements are such that the etching resistance of the regions 6 which are implanted is increased. With increased etching resistance is meant that the locally modified regions 6 have a reduced etching speed with respect to the starting or original substrate 1. Most preferably, the implantation elements may be C, N, O or a combination thereof. Preferably, an implantation dose of between 1E13 cm⁻² and 1E17 cm⁻² may be used. During implantation of the implantation elements in the exposed parts of the bulk semiconductor substrate 1, the hardmask 4 may act as a shield for preventing implantation elements to be implanted in the at least one structure 20. This is because the presence of implantation elements in the at least one structure 20 can lead to increased sidewall roughness of the at least one structure 20. Furthermore, the presence of implantation elements in the at least one structure 20 may lead to scattering of mobile carriers which may affect mobility of the mobile carriers in the at least one structure 20 which may later serve as e.g. a gate. According to embodiments of the invention, implantation may be performed in an anisotropic way. Implantation may be done in, when the bulk semiconductor substrate 1 has a major surface lying in a plane, a direction substantially perpendicular to the plane of the major surface of the substrate 1. With substantially perpendicular is meant that the direction of implantation of the implantation elements may most preferably make an angle of between 0 and 5 degrees with the direction substantially perpendicular to the plane of the major surface of the substrate 1 such that substantially no implantation elements can enter the at least one structure 20 through its sidewalls which are not covered by the mask 4. With substantially no implantation elements entering the at least one structure 20 is meant that a concentration of preferably less than 1 E 12 cm⁻² and more preferably less than 1E10 cm⁻² of implantation elements may enter the at least one structure 20 during implantation of implantation elements to form the locally modified regions 6. Therefore, most preferably, implantation may be performed with PLAD (plasma doping), as was already described in the first embodiment.

According to other embodiments, implantation of implantation elements may also be performed by any other known conventional implantation technique such as e.g. ion implantation. For example, according to other, though less preferred, embodiments of the invention, any plasma having an anisotropic character may be applied for implanting implantation elements, as long as the direction of implantation is substantially parallel to the formed structure 20 as was described above, e.g. remote plasma or RIE.

During implantation of implantation elements the hardmask 4 which is still present on the at least one structure 20 may act as a shield for preventing implantation elements to be implanted into the at least one structure 20. Therefore, the thickness and the material properties of the hardmask 4 should be chosen such that after implantation only a part 8 of the hardmask 4 is implanted with implantation elements and that the implantation elements are not able to reach the at least one structure 20 (see Fig. 10). By implanting the implantation elements in a direction substantially parallel to the formed structure 20, preferably substantially perpendicular to the plane of the major surface of the bulk semiconductor substrate 1, no implantation elements are implanted in sidewalls of the at least one structure 20.

After implantation of the implantation elements in the exposed parts of the bulk semiconductor substrate 1, the locally modified regions 6 may optionally be extended underneath the at least one structure 20. This may preferably be performed by annealing the substrate 1. Annealing may be performed at temperatures of between 800°C and 1000°C for a period of between 1 second and 60 seconds. The locally modified regions 6 may have a thickness t in the bulk semiconductor substrate 1 of, for example, between 1 nm and 20 nm, preferably between 1 nm and 10 nm.

The presence of locally modified regions 6 in accordance with embodiments of the present invention may be detected by, for example, chemical analysis of the substrate, for example, by filtered transmission electron microscopy (TEM).

In a next step, the hardmask 4 may be removed. This may be done by any suitable technique known by a person skilled in the art, such as stripping.

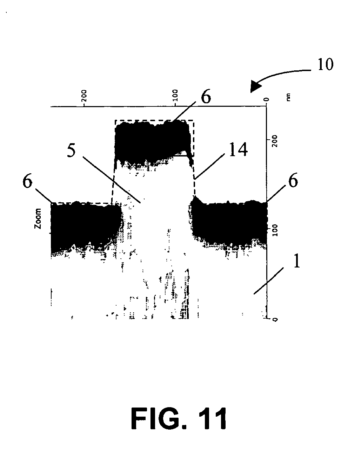

Figure 11 shows a Scanning Spreading Resistance Measurement (SSRM) profile of a bulk FinFET, i.e. a FinFET formed on a bulk semiconductor substrate 1, in the example given a silicon substrate 1. A fin 6 is protruding from a bulk silicon substrate 2. This fin 5 is then doped using PLAD. As can be seen from figure 11 (darker regions) implantation occurs in the regions indicated with reference number 6 and on top of the fin 5 but not in the upstanding surfaces or sidewalls 14 of the fin 5 which remain substantially unaffected by the PLAD doping process.

Further manufacturing of the semiconductor device 10 may be done as known by a person skilled in the art and depends on the semiconductor device 10 required to be formed.

During process steps performed after formation of the locally modified regions 6, these locally modified regions 6 with increased etching resistance protect the substrate 1 against influence of materials and chemicals further used during manufacturing of the semiconductor device 10. This prevents recesses and under-etch regions under the fin 5 to be formed in the substrate 1. Hence, residues of materials or chemicals further used during the manufacturing of the semiconductor device 10 cannot stick in these recesses and under-etch regions as they do not exist. Hence, no additional process steps are required for removing these residues.

The methods according to embodiments of the invention lead to semiconductor devices with good electrical properties and good mechanical stability.

It is to be understood that although preferred embodiments, specific constructions and configurations, as well as materials, have been discussed herein for devices according to the present invention, various changes or modifications in form and detail may be made without departing from the scope and spirit of this invention.

## Claims

1. A method for forming a semiconductor device (10) on a substrate (1) having a first major surface lying in a plane, the method comprising:
- patterning the first major surface of the substrate (1) to form at least one structure (20) extending from the substrate (1) in a direction substantially perpendicular to the plane of the first major surface, and
- forming locally modified regions (6) at locations in the substrate (1) which are not covered by the at least one structure (20), thus locally increasing etching resistance of these regions (6).

2. A method according to claim 1, wherein locally increasing etching resistance prevents under-etching of the at least one structure (20) during further process steps in the formation of the semiconductor device (10).

3. A method according to any of the previous claims, wherein forming locally modified regions (6) is performed by implanting implantation elements in a direction substantially perpendicular to the plane of the first major surface.

4. A method according to any of the previous claims, the substrate (1) being a semiconductor-on-insulator substrate comprising a semiconductor layer (3) on an insulating layer (2) having a surface, wherein:
- patterning the substrate comprises patterning the semiconductor layer (3), and
- forming locally modified regions comprises forming locally modified regions (6) in the insulating layer (2) at locations which are not covered by the at least one structure (20).

5. A method according to any of claims 1 to 3, the substrate (1) being a bulk semiconductor substrate, wherein:
- patterning the substrate (1) comprises patterning the bulk semiconductor substrate (1), and
- forming locally modified regions comprises forming locally modified regions (6) in the bulk semiconductor substrate (1).

6. A method according to any of claims 3 to 5, wherein implanting implantation elements is performed by ion implantation.

7. A method according to any of claims 3 to 5, wherein implanting implantation elements is performed by plasma doping.

8. A method according to any of claims 3 to 7, wherein implanting implantation elements is performed at a dose of between 1E13 cm⁻² and 1E17 cm⁻².

9. A method according to any of claims 3 to 8, wherein the implantation elements comprise carbon, nitrogen, oxygen or a combination thereof.

10. A method according to any of the previous claims, wherein the method furthermore comprises extending the locally modified regions (6) under the at least one structure (20).

11. A method according to claim 10, wherein extending the locally modified regions (6) under the at least one structure (20) leads to formation of locally modified regions (6) with a thickness (t) of between 1 nm and 20 nm.

12. A method according to claim 10 or 11, wherein extending the locally modified regions (6) under the at least one structure (20) is performed by annealing.

13. A method according to claim 12, wherein annealing is performed at a temperature of between 800°C and 1000°C.

14. A method according to any of claims 12 or 13, wherein annealing is performed during a time period of between 1 second and 60 seconds.

15. A method according to any of the previous claims, wherein patterning the substrate (1) is performed by:
- providing a mask (4) onto the substrate (1), and
- removing parts of the substrate (1) which are not covered by the mask (4).

16. A method according to claim 15, wherein providing a mask (4) comprises providing a hardmask comprising at least one of a metal, a nitride, an oxide or a low-k material.

17. A method according to claim 15, wherein providing a mask (4) comprises providing a photoresist polymer.

18. A semiconductor device (10) comprising at least one structure (20) extending from a substrate (1) having a first major surface lying in a plane, the at least one structure extending in a direction substantially perpendicular to the plane of the first major surface of the substrate (1), wherein the semiconductor device (10) furthermore comprises locally modified regions (6) in the substrate at locations not covered by the at least one structure (20), the locally modified regions (6) having an increased etch resistance with respect to the etch resistance of the non-modified substrate (1).

19. A semiconductor device (10) according to claim 18, the substrate (1) being a semiconductor-on-insulator substrate and the semiconductor device (10) comprising a patterned semiconductor layer (5) on an insulating layer (2) of the semiconductor-on-insulator substrate (1), the insulating layer (2) having a surface, wherein the locally modified regions in the substrate are locally modified regions (6) at the surface of the insulating layer (2) at locations which are not covered by the patterned semiconductor layer (5).

20. A semiconductor device (10) according to claim 19, wherein the locally modified regions (6) in the insulating layer (2) comprise SiOₓN_{y}, wherein x and y are integers and x+y = 1.

21. A semiconductor device according to claim 18, wherein the substrate (1) is a bulk semiconductor substrate.

22. A semiconductor device (10) according to any of claim 18 to 21, wherein the locally modified regions (6) are regions implanted with carbon, nitrogen, oxygen or a combination thereof.

23. A semiconductor device (10) according to claim 22, wherein the locally modified regions (6) have a concentration of carbon, nitrogen and/or oxygen of between 1E13 cm⁻² and 1E17 cm⁻².

24. A semiconductor device (10) according to any of claims 18 to 23, wherein the locally modified regions (6) have a thickness (t) of between 1 nm and 20 nm.

25. A semiconductor device (10) according to any of claims 28 to 24, wherein the locally modified regions (6) extend underneath the at least one structure (20).

26. A semiconductor device (10) according to any of claims to 25, wherein the semiconductor device (10) is a FinFET.

## Amended claims

### Amended claims in accordance with Rule 137(2) EPC.

**1.** A method for forming a semiconductor device (10) on a substrate (1) having a first major surface lying in a plane, the method comprising:
- patterning the first major surface of the substrate (1) to form at least one structure (20) extending from the substrate (1) in a direction substantially perpendicular to the plane of the first major surface, and
- forming locally modified regions (6) at locations in the substrate (1) which are not covered by the at least one structure (20), thus locally increasing etching resistance of these regions (6),
**characterised in that** forming locally modified regions (6) is performed by implanting implantation elements in a direction substantially perpendicular to the plane of the first major surface.

**2.** A method according to claim 1, wherein locally increasing etching resistance prevents under-etching of the at least one structure (20) during further process steps in the formation of the semiconductor device (10).

**3.** A method according to any of the previous claims, the substrate (1) being a semiconductor-on-insulator substrate comprising a semiconductor layer (3) on an insulating layer (2) having a surface, wherein:
- patterning the substrate comprises patterning the semiconductor layer (3), and
- forming locally modified regions comprises forming locally modified regions (6) in the insulating layer (2) at locations which are not covered by the at least one structure (20).

**4.** A method according to any of claims 1 to 2, the substrate (1) being a bulk semiconductor substrate, wherein:
- patterning the substrate (1) comprises patterning the bulk semiconductor substrate (1), and
- forming locally modified regions comprises forming locally modified regions (6) in the bulk semiconductor substrate (1).

**5.** A method according to any of the previous claims, wherein implanting implantation elements is performed by ion implantation.

**6.** A method according to any of the previous claims, wherein implanting implantation elements is performed by plasma doping.

**7.** A method according to any of the previous claims, wherein implanting implantation elements is performed at a dose of between 1E13 cm⁻² and 1E17 cm-².

**8.** A method according to any of the previous claims, wherein the implantation elements comprise carbon, nitrogen, oxygen or a combination thereof.

**9.** A method according to any of the previous claims, wherein the method furthermore comprises extending the locally modified regions (6) under the at least one structure (20).

**10.** A method according to claim 9, wherein extending the locally modified regions (6) under the at least one structure (20) leads to formation of locally modified regions (6) with a thickness (t) of between 1 nm and 20 nm.

**11.** A method according to claim 9 or 10, wherein extending the locally modified regions (6) under the at least one structure (20) is performed by annealing.

**12.** A method according to claim 11, wherein annealing is performed at a temperature of between 800°C and 1000°C.

**13.** A method according to any of claims 11 or 12, wherein annealing is performed during a time period of between 1 second and 60 seconds.

**14.** A method according to any of the previous claims, wherein patterning the substrate (1) is performed by:
- providing a mask (4) onto the substrate (1), and
- removing parts of the substrate (1) which are not covered by the mask (4).

**15.** A method according to claim 14, wherein providing a mask (4) comprises providing a hardmask comprising at least one of a metal, a nitride, an oxide or a low-k material.

**16.** A method according to claim 14, wherein providing a mask (4) comprises providing a photoresist polymer.

**17.** A semiconductor device (10) comprising at least one structure (20) extending from a substrate (1) having a first major surface lying in a plane, the at least one structure extending in a direction substantially perpendicular to the plane of the first major surface of the substrate (1), wherein the semiconductor device (10) furthermore comprises locally modified regions (6) in the substrate at locations not covered by the at least one structure (20), the locally modified regions (6) having an increased etch resistance with respect to the etch resistance of the non-modified substrate (1), **characterized in that** the locally modified regions (6) comprise implanted implantation elements.

**18.** A semiconductor device (10) according to claim 17, the substrate (1) being a semiconductor-on-insulator substrate and the semiconductor device (10) comprising a patterned semiconductor layer (5) on an insulating layer (2) of the semiconductor-on-insulator substrate (1), the insulating layer (2) having a surface, wherein the locally modified regions in the substrate are locally modified regions (6) at the surface of the insulating layer (2) at locations which are not covered by the patterned semiconductor layer (5).

**19.** A semiconductor device (10) according to claim 18, wherein the locally modified regions (6) in the insulating layer (2) comprise SiOₓN_{y}, wherein x and y are integers and x+y = 1.

**20.** A semiconductor device according to claim 17, wherein the substrate (1) is a bulk semiconductor substrate.

**21.** A semiconductor device (10) according to any of claim 17 to 20, wherein the implantation elements comprise carbon, nitrogen, oxygen or a combination thereof.

**22.** A semiconductor device (10) according to claim 21, wherein the locally modified regions (6) have a concentration of carbon, nitrogen and/or oxygen of between 1E13 cm⁻² and 1E17 cm⁻².

**23.** A semiconductor device (10) according to any of claims 17 to 22, wherein the locally modified regions (6) have a thickness (t) of between 1 nm and 20 nm.

**24.** A semiconductor device (10) according to any of claims 17 to 23, wherein the locally modified regions (6) extend underneath the at least one structure (20).

**25.** A semiconductor device (10) according to any of claims 17 to 24, wherein the semiconductor device (10) is a FinFET.
